# EUROPEAN PATENT APPLICATION

(11) **EP 4 722 813 A1**
(43) Date of publication of application: **08.04.2026**
(21) Application number: 24205036.7
(22) Date of filing: 07.10.2024
(51) Int. Cl.: G03F 7/20

(54) **METHOD OF DETERMINING A PARAMETER ASSOCIATED WITH A FLUID HANDLING STRUCTURE AND/OR WETTABILITY OF A SUBSTRATE IN IMMERSION LITHOGRAPHY, CORRESPONDING METHOD OF MANUFACTURING A DEVICE IN A LITHOGRAPHIC APPARATUS AND A CORRESPONDING LITHOGRAPHIC APPARATUS**

(71) Applicant: ASML Netherlands B.V., 5500 AH Veldhoven (NL)
(72) Inventor: BERENDSEN, Christianus, Wilhelmus, Johannes, 5500 AH Veldhoven (NL); EUMMELEN, Erik, Henricus, Egidius, Catharina, 5500 AH Veldhoven (NL); GATTOBIGIO, Giovanni, Luca, 5500 AH Veldhoven (NL); BLOKS, Ruud, Hendrikus, Martinus, Johannes, 5500 AH Veldhoven (NL)
(74) Representative: ASML Netherlands B.V.

(57) **Abstract**

The present disclosure relates to methods for a lithographic apparatus comprising a fluid handling structure configured to confine a fluid to a region of a surface of a substrate. The methods are for determining a parameter associated with the fluid handling structure and/or the wettability of the substrate. Some methods comprise causing a movement of the fluid handling structure relative to the substrate, wherein a speed of the fluid handling structure relative to the substrate during the movement varies as a function of the position of the fluid handling structure relative to the substrate; and then inspecting the surface of the substrate, or wherein the fluid handling structure passes over a fluid-pinning feature during the movement of the fluid handling structure relative to the substrate; and then inspecting the surface of the substrate, or determining a thermal load on the substrate.

## Description

### FIELD

The present invention relates to a method of determining a parameter associated with a fluid handling structure and/or the wettability of a substrate. The fluid handling structure is configured to confine a fluid to a region of the surface of the substrate. The determination of the parameter is based on the inspecting of a surface of the substrate.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer). Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm.

Further improvements in the resolution of smaller features may be achieved by providing an immersion liquid having a relatively high refractive index, such as water, on the substrate during exposure. The effect of the immersion liquid is to enable imaging of smaller features since the exposure radiation will have a shorter wavelength in the liquid than in gas. The effect of the immersion liquid may also be regarded as increasing the effective numerical aperture (NA) of the system and also increasing the depth of focus. In immersion lithography, a fluid handling structure is configured to confine the immersion liquid to a region of the substrate.

In an immersion lithography process, defects in printed patterns can occur due to the presence of bubbles of gas in the immersion liquid and/or droplets of immersion liquid that are lost from the fluid handling structure and left on the surface of the substrate. Many approaches to minimising the creation of such bubbles and droplets, and to ameliorate their effects, have been proposed. For example, it has been proposed to provide a CO₂ environment adjacent the immersion liquid; special coatings on the substrate and substrate support; and extracting gas and liquid from a gap between the edge of the substrate and the substrate support. However, it has not so far been possible to completely eliminate the occurrence of bubbles and droplets and the defects that they cause.

### SUMMARY

In many cases, the rate of defects can be reduced by slowing down a scanning speed or other recipe modifications. However, slowing down scanning speeds (and other recipe modifications) reduce the throughput of the lithographic apparatus.

The present disclosure relates to techniques for effectively assessing/analysing immersion liquid that lost from a fluid handling structure during use. By being able to effectively assess immersion liquid during use, the immersion lithographic apparatus can be controlled to maximise throughput while avoiding defectivity.

According to an aspect of the present disclosure, there is provided a method for a lithographic apparatus comprising a fluid handling structure, wherein the fluid handling structure is configured to confine a fluid to a region of a surface of a substrate. The method comprises: causing a movement of the fluid handling structure relative to the substrate, wherein a speed of the fluid handling structure relative to the substrate during the movement varies as a function of the position of the fluid handling structure relative to the substrate; inspecting the surface of the substrate; determining a parameter associated with the fluid handling structure and/or the wettability of the substrate based on the inspecting of the surface of the substrate.

According to another aspect of the present disclosure, there is provided a method for a lithographic apparatus comprising a fluid handling structure, wherein the fluid handling structure is configured to confine a fluid to a region of a surface of a substrate. The method comprises: causing a movement of the fluid handling structure relative to the substrate, wherein the fluid handling structure passes over a fluid-pinning feature during the movement of the fluid handling structure relative to the substrate; inspecting the surface of the substrate; and determining a parameter associated with the fluid handling structure and/or the wettability of the substrate based on the inspecting of the surface of the substrate.

According to another aspect of the present disclosure, there is provided a method for a lithographic apparatus comprising a fluid handling structure, wherein the fluid handling structure is configured to confine a fluid to a region of a surface of a substrate, and the method comprises: causing a movement of the fluid handling structure relative to the substrate; determining a thermal load on the substrate; and determining a parameter associated with the fluid handling structure and/or the wettability of the substrate based on the thermal load on the substrate.

Further embodiments, features and advantages of the present invention, as well as the structure and operation of the various embodiments, features and advantages of the present invention are described in detail below with reference to the accompanying drawings.

### DESCRIPTION OF THE DRAWINGS

Embodiments of the invention will now be described, by way of example only, with reference to the accompanying schematic drawings, in which corresponding reference symbols indicate corresponding parts, and in which:
Figure 1 schematically depicts a schematic overview of the lithographic apparatus;
Figure 2 schematically depicts, in cross-section, a version of a fluid handling system for use in a lithographic projection apparatus;
Figure 3 schematically depicts, in cross-section, another version of a fluid handling system for use in a lithographic projection apparatus;
Figure 4 schematically depicts, in cross-section, a substrate support and a substrate W.
Figure 5 is a diagram illustrating an exemplary route for a production exposure of a substrate W.
Figure 6 schematically depicts a path of a fluid handling structure IH over a substrate W, and signs of fluid remaining on the surface of the substrate W.
Figure 7 schematically depicts the phenonium of fluid-pinning at an edge of a substrate W.
Figure 8 schematically depicts a path of a fluid handling structure IH over a substrate W, and signs of fluid remaining on the surface of the substrate W.
Figure 9 depicts a fluid loss pattern identified from signs of fluid remaining on the surface of the substrate W.
Figure 10 depicts a plot of an angle of the fluid loss pattern against the speed of the fluid handling structure IH relative to the substrate W.
Figure 11 depicts a plot of the thermal load on a substrate W against the speed of the fluid handling structure IH relative to the substrate W.
Figure 12 depicts four paths of a fluid handing structure over the surface of a substrate W.
Figure 13 depicts several paths of a fluid handling structure IH over the surface of a substrate W.

The features shown in the Figures are not necessarily to scale, and the size and/or arrangement depicted is not limiting. It will be understood that the Figures include optional features which may not be essential to the invention. Furthermore, not all of the features of the apparatus are depicted in each of the figures, and the Figures may only show some of the components relevant for describing a particular feature.

### DETAILED DESCRIPTION

In the present document, the terms "radiation" and "beam" are used to encompass all types of electromagnetic radiation, including ultraviolet radiation (e.g., with a wavelength of 365, 248, 193, 157 or 126 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate W. The term "light valve" can also be used in this context. Besides the classic mask (transmissive or reflective, binary, phase-shifting, hybrid, etc.), examples of other such patterning devices include a programmable mirror array and a programmable LCD array.

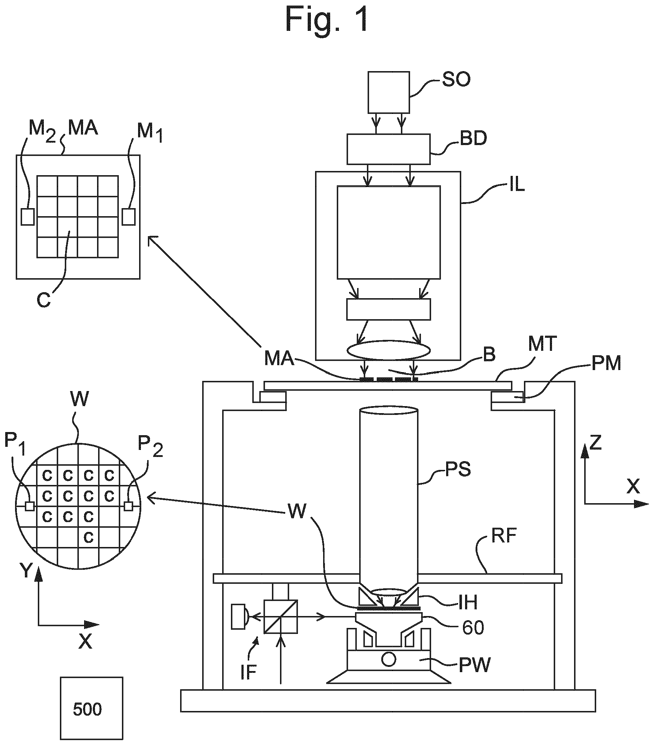

Figure 1 schematically depicts a lithographic apparatus. The lithographic apparatus includes an illumination system (also referred to as illuminator) IL configured to condition a radiation beam B (e.g., UV radiation or DUV radiation), a mask support (e.g., a mask table) MT constructed to support a patterning device (e.g., a mask) MA and connected to a first positioner PM configured to accurately position the patterning device MA in accordance with certain parameters, a substrate table (e.g., a support table or a substrate support) 60 constructed to hold a substrate W (e.g., a resist coated wafer) W and connected to a second positioner PW configured to accurately position the substrate table 60 in accordance with certain parameters, and a projection system (e.g., a refractive projection lens system) PS configured to project a pattern imparted to the radiation beam B by patterning device MA onto a target portion C (e.g., comprising one or more dies) of the substrate W. The substrate table 60 may optionally comprise a substrate support (not shown in Figure 1) constructed to hold the substrate W.

In operation, the illumination system IL receives the radiation beam B from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross-section at a plane of the patterning device MA.

The term "projection system" used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system".

The lithographic apparatus is of a type wherein at least a portion of the substrate W may be covered by an immersion liquid having a relatively high refractive index, e.g., water, so as to fill an immersion space 11 between the projection system PS and the substrate W - which is also referred to as immersion lithography. More information on immersion techniques is given in US 6,952,253, which is incorporated herein by reference.

The lithographic apparatus may be of a type having two or more substrate tables 60 (also named "dual stage"). In such a "multiple stage" machine, the substrate tables 60 may be used in parallel, and/or steps in preparation of a subsequent exposure of the substrate W may be carried out on the substrate W located on one of the substrate table 60 while another substrate W on the other substrate table 60 is being used for exposing a pattern on the other substrate W.

In addition to the substrate table 60, the lithographic apparatus may comprise a measurement stage (not depicted in figures). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate table 60 is away from the projection system PS.

In operation, the radiation beam B is incident on the patterning device MA, e.g., mask, which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate table 60 can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

Immersion techniques have been introduced into lithographic systems to enable improved resolution of smaller features. In an immersion lithographic apparatus, a liquid layer of immersion liquid having a relatively high refractive index is interposed in the immersion space 11 between a projection system PS of the apparatus (through which the patterned radiation beam B is projected towards the substrate W) and the substrate W. The immersion liquid covers at least the part of the substrate W under a final element of the projection system PS. Thus, at least the portion of the substrate W undergoing exposure is immersed in the immersion liquid.

In commercial immersion lithography, the immersion liquid is water. Typically the water is distilled water of high purity, such as Ultra-Pure Water (UPW) which is commonly used in semiconductor fabrication plants. In an immersion system, the UPW is often purified and it may undergo additional treatment steps before supply to the immersion space 11 as immersion liquid. Other liquids with a high refractive index can be used besides water as the immersion liquid, for example: a hydrocarbon, such as a fluorohydrocarbon; and/or an aqueous solution. Further, other fluids besides liquid have been envisaged for use in immersion lithography.

In this specification, reference will be made in the description to localized immersion in which the immersion liquid is confined, in use, to the immersion space 11 between the final element and a surface facing the final element. The facing surface is a surface of substrate W or a surface of the supporting stage (or substrate table 60) that is co-planar with the surface of the substrate W. (Please note that reference in the following text to surface of the substrate W also refers in addition or in the alternative to the surface of the substrate table 60, unless expressly stated otherwise; and vice versa). A fluid handling structure IH present between the projection system PS and the substrate table 60 is used to confine the immersion liquid to the immersion space 11. The immersion space 11 filled by the immersion liquid is smaller in plan than the top surface of the substrate W.

In use of the lithographic apparatus, the immersion space 11 and the top surface of the substrate W may move relative to one another. That is, the fluid handling structure IH (and therefore the immersion space 11) moves relative to the top surface of the substrate W. Most commonly, the fluid handling structure IH (and therefore the immersion space 11) remains substantially stationary (relative to the projection system PS), and the relative movement between the fluid handling structure IH and the top surface of the substrate W is brought about by moving the substrate W and substrate table 60. However, in some lithographic apparatuses, the relative movement between the fluid handling structure IH and the top surface of the substrate W may be brought about by moving the fluid handling structure IH, and the substrate W and substrate table 60 may remain stationary. In some lithographic apparatuses, the relative movement between the fluid handling structure IH and the top surface of the substrate W may be brought about by a combination of moving the fluid handling structure IH, and moving the substrate W/substrate table 60. In the following description, movements of the fluid handling structure IH refers to the relative movement of the fluid handling structure IH and the substrate W, which may be brought about in any of the ways described above.

Other immersion systems have been envisaged such as an unconfined immersion system (a so-called 'All Wet' immersion system) and a bath immersion system. In an unconfined immersion system, the immersion liquid covers more than the surface under the final element. The liquid outside the immersion space 11 is present as a thin liquid film. The liquid may cover the whole surface of the substrate W or even the substrate W and the substrate support WT co-planar with the substrate W. In a bath type system, the substrate W is fully immersed in a bath of immersion liquid.

The fluid handling structure IH is a structure which supplies the immersion liquid to the immersion space 11, removes the immersion liquid from the immersion space 11 and thereby confines the immersion liquid to the immersion space 11. It includes features which are a part of a fluid supply system. The arrangement disclosed in PCT patent application publication no. WO 99/49504 is an early fluid handling structure IH comprising pipes which either supply or recover the immersion liquid from the immersion space 11 and which operate depending on the relative motion of the stage beneath the projection system PS. In more recent designs, the fluid handling structure IH extends along at least a part of a boundary of the immersion space 11 between the final element of the projection system PS and the substrate table 60 or substrate W, so as to in part define the immersion space 11.

The fluid handing structure IH may have a selection of different functions. Each function may be derived from a corresponding feature that enables the fluid handling structure IH to achieve that function. The fluid handling structure IH may be referred to by a number of different terms, each referring to a function, such as barrier member, seal member, fluid supply system, fluid removal system, liquid confinement structure, etc..

Immersion liquid may be used as the immersion fluid. In that case the fluid handling structure IH may be a liquid handling system. In reference to the aforementioned description, reference in this paragraph to a feature defined with respect to fluid may be understood to include a feature defined with respect to liquid.

A lithographic apparatus has a projection system PS. During exposure of a substrate W, the projection system PS projects a patterned radiation beam B onto the substrate W. To reach the substrate W, the path of the radiation beam B passes from the projection system PS through the immersion liquid confined by the fluid handling structure IH between the projection system PS and the substrate W. The projection system PS has a lens element, the last in the path of the beam, which is in contact with the immersion liquid. This lens element which is in contact with the immersion liquid may be referred to as 'the last lens element' or "the final element". The final element is at least partly surrounded by the fluid handling structure IH. The fluid handling structure IH may confine the immersion liquid under the final element and above the facing surface.

As depicted in Figure 1, the lithographic apparatus comprises a controller or control system 500. The controller or control system 500 is configured to control the substrate table 60.

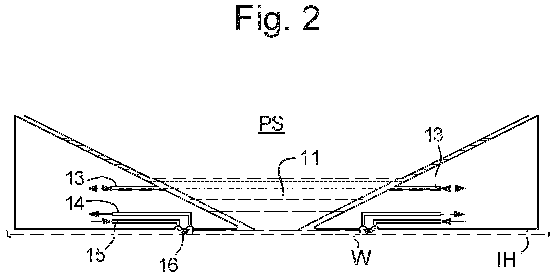

Figure 2 schematically depicts a localized liquid supply system or fluid handling system. The liquid supply system is provided with a fluid handling structure IH (or liquid confinement structure), which extends along at least a part of a boundary of the immersion space 11 between the final element of the projection system PS and the substrate table 60 and/or substrate W. The fluid handling structure IH is substantially stationary relative to the projection system PS in the XY plane though there may be some relative movement in the Z direction (in the direction of the optical axis). In an example, a seal is formed between the fluid handling structure IH and the surface of the substrate W and may be a contactless seal such as a gas seal (such a system with a gas seal is disclosed in EP1,420,298) or liquid seal.

The fluid handling structure IH at least partly confines the immersion liquid in the immersion space 11 between the final element of the projection system PS and the substrate W. The immersion space 11 is at least partly formed by the fluid handling structure IH positioned below and surrounding the final element of the projection system PS. Immersion liquid is brought into the immersion space 11 below the projection system PS and within the fluid handling structure IH by one of liquid openings 13. The immersion liquid may be removed by another of liquid openings 13. The immersion liquid may be brought into the immersion space 11 through at least two liquid openings 13. Which of liquid openings 13 is used to supply the immersion liquid and optionally which is used to remove the immersion liquid may depend on the direction of motion of the substrate table 60.

The immersion liquid may be confined in the immersion space 11 by a contactless seal such as a gas seal 16 formed by a gas which, during use, is formed between the bottom of the fluid handling structure IH and the surface of the substrate W. The gas in the gas seal 16 is provided under pressure via inlet 15 to the gap between the fluid handling structure IH and substrate W. The gas is extracted via outlet 14. The overpressure on the gas inlet 15, vacuum level on the outlet 14 and geometry of the gap are arranged so that there is a high-velocity gas flow inwardly that confines the immersion liquid. Such a system is disclosed in US 2004/0207824, which is hereby incorporated by reference in its entirety. In an example, the fluid handling structure IH does not have the gas seal 16.

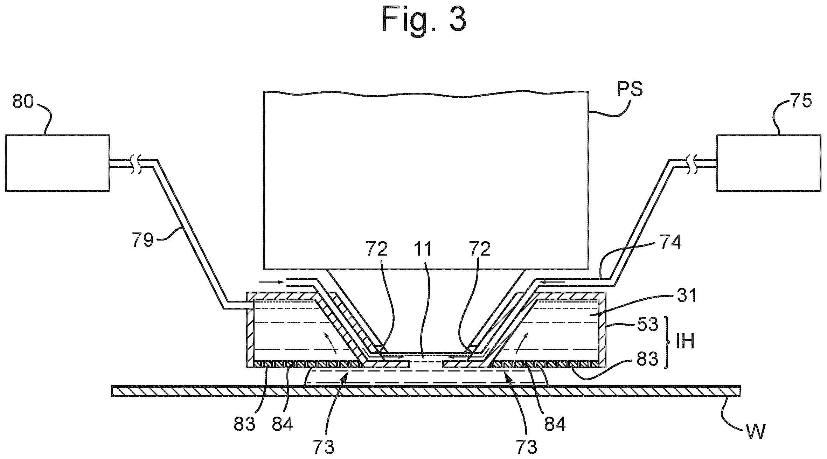

Figure 3 is a side cross-sectional view that depicts a further liquid supply system or fluid handling system. The arrangement illustrated in Figure 3 and described below may be applied to the lithographic apparatus described above and illustrated in Figure 1. The liquid supply system is provided with a fluid handling structure IH (or a liquid confinement structure), which extends along at least a part of a boundary of the immersion space 11 between the final element of the projection system PS and the substrate support WT or substrate W.

The fluid handling structure IH at least partly confines the immersion liquid in the immersion space 11 between the final element of the projection system PS and the substrate W. The immersion space 11 is at least partly formed by the fluid handling structure IH positioned below and surrounding the final element of the projection system PS. In an example, the fluid handling structure IH comprises a main body member 53 and a porous member 33. The porous member 33 is plate shaped and has a plurality of holes (i.e., openings or pores). The porous member 33 may be a mesh plate wherein numerous small holes 84 are formed in a mesh. Such a system is disclosed in US 2010/0045949 A1, which is hereby incorporated by reference in its entirety.

The main body member 53 comprises supply ports 72, which are capable of supplying the immersion liquid to the immersion space 11, and a recovery port 73, which is capable of recovering the immersion liquid from the immersion space 11. The supply ports 72 are connected to a liquid supply apparatus 75 via passageways 74. The liquid supply apparatus 75 is capable of supplying the immersion liquid to the supply ports 72 through the corresponding passageway 74. The recovery port 73 is capable of recovering the immersion liquid from the immersion space 11. The recovery port 73 is connected to a liquid recovery apparatus 80 via a passageway 79. The liquid recovery apparatus 80 recovers the immersion liquid recovered via the recovery port 73 through the passageway 29. The porous member 33 is disposed in the recovery port 73. Performing the liquid supply operation using the supply ports 72 and the liquid recovery operation using the porous member 33 forms the immersion space 11 between the projection system PS and the fluid handling structure IH on one side and the substrate W on the other side.

As the fluid handling structure IH moves relative to the substrate W, some immersion liquid may be lost from the confines of the fluid handling structure IH. Lost immersion liquid may remain on the top surface of the substrate W in the form of droplets. Droplets that are left on the top surface of the substrate W may evaporate, leaving watermarks or stains. Droplets, watermarks and stains can cause defectivity in the pattern that is imparted to the photoresist during imaging of the portion of the substrate W on which the droplet/watermark/stain is present. The designs of the fluid handling structure IH described above may be configured to limit the loss of immersion liquid as the fluid handling structure IH moves relative to the substrate W. However, some loss of immersion liquid may still occur.

Within the lithographic apparatus, the substrate W may be held by a support body (e.g. a pimple or burl table). The support body may be referred to as a substrate support. The substrate support may be a part of or integral with the substrate table 60 shown in Figure 1.

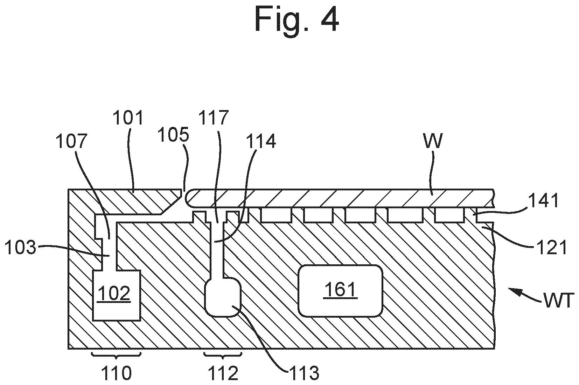

Figure 4 illustrates a cross-section through radially outward portion a substrate support WT and a substrate W. In an embodiment, the substrate support WT comprises one or more conditioning channels 161 of a thermal conditioner, which is described in more detail below. A gap 105 exists between an edge of the substrate W and an edge of the substrate support WT. When the edge of the substrate W is being imaged or at other times such as when the substrate W first moves under the projection system PS (as described above), the immersion space 11 filled with liquid by the fluid handling structure IH (for example) will pass at least partly over the gap 105 between the edge of the substrate W and the edge of the substrate support WT. This can result in liquid from the immersion space 11 entering the gap 105.

The substrate W is held by the substrate support WT comprising a support body 121 comprising one or more burls 141 (i.e., projections from the surface). The support body 121 is an example of an object holder. Another example of an object holder is a mask holder. An underpressure applied between the substrate W and the substrate support WT helps ensure that the substrate W is held firmly in place.

In order to deal with the immersion liquid entering that gap 105 at least one drain 110, 112 is provided at the edge of the substrate W to remove immersion liquid which enters the gap 105. In the embodiment of Figure 4 two drains 110, 112 are illustrated though there may only be one drain or there could be more than two drains. In an embodiment, each of the drains 110, 112 is annular so that the whole periphery of the substrate W is surrounded.

A primary function of the first drain 110 (which is radially outward of the edge of the substrate W/support body 121) is to help prevent bubbles of gas from entering the immersion space 11 where the liquid of the fluid handling structure IH is present. Such bubbles may deleteriously affect the imaging of the substrate W. The first drain 110 is present to help avoid gas in the gap 105 escaping into the immersion space 11 in the fluid handling structure IH. If gas does escape into the immersion space 11, this can lead to a bubble which floats within the immersion space 11. Such a bubble, if in the path of the radiation beam B, may lead to an imaging error. The first drain 110 is configured to remove gas from the gap 105 between the edge of the substrate W and the edge of the recess in the substrate support WT in which the substrate W is placed. The edge of the recess in the substrate support WT may be defined by a cover ring 101 which is optionally separate from the support body 21 of the substrate support WT. The cover ring 101 may be shaped, in plan, as a ring and surrounds the outer edge of the substrate W. The first drain 110 extracts mostly gas and only a small amount of immersion liquid.

The second drain 112 (which is radially inward of the edge of the substrate W/support body 121) is provided to help prevent liquid which finds its way from the gap 105 to underneath the substrate W from preventing efficient release of the substrate W from the substrate support WT after imaging. The provision of the second drain 112 reduces or eliminates any problems which may occur due to liquid finding its way underneath the substrate W.

As depicted in Figure 4, in an embodiment the lithographic apparatus comprises a first extraction channel 102 and a second extraction channel 113 for the passage therethrough of a two-phase flow. The first extraction channel 102 and/or the second extraction channel 113 may be formed within the support body 121 or as a separate component. The first and second drains 110, 112 are each provided with a respective opening 107, 117 and a respective extraction channel 102, 113. The extraction channel 102, 113 is in fluid communication with the respective opening 107, 117 through a respective passageway 103, 114.

As depicted in Figure 4, the cover ring 101 has an upper surface. The upper surface extends circumferentially around the substrate W on the support body 121. As described above, in use of the lithographic apparatus, the fluid handling structure IH moves relative to the substrate support WT. During this relative movement, the fluid handling structure IH moves across the gap 105 between the cover ring 101 and the substrate W.

During operations within a lithographic apparatus, the relative movement between the fluid handling structure IH and the substrate W (which, most commonly, is brought about by movement of the substrate support WT while the fluid handling structure IH remains stationary) is such that the fluid handling structure IH moves across the top surface of the substrate W along a path. The path may also be referred to as a route. The path along which the fluid handling structure IH moves across the top surface of the substrate W may be the path along which the substrate support WT is moved to cause the relative movement between the fluid handling structure IH and the substrate W.

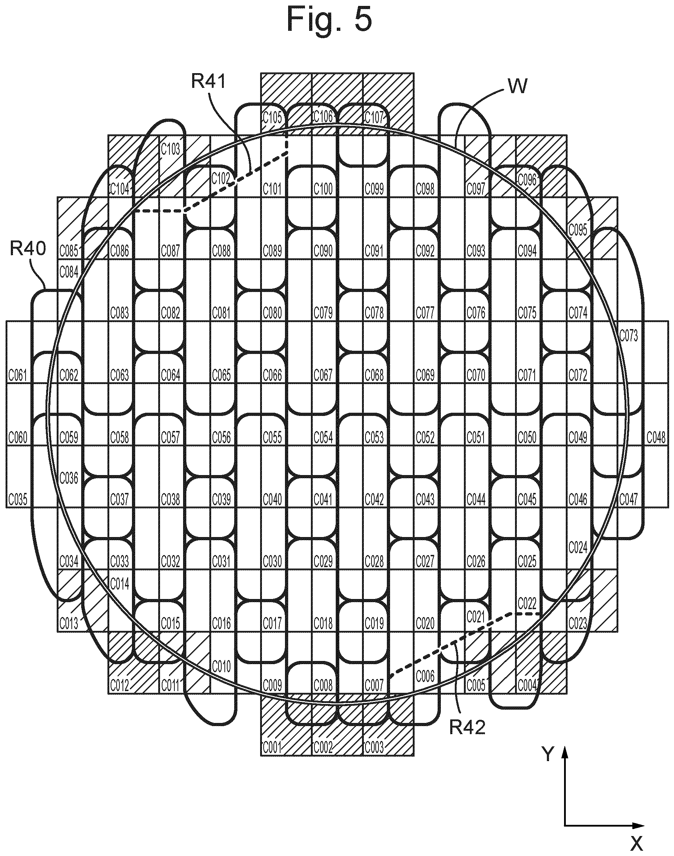

Figure 5 depicts an exemplary route R40 followed by a substrate W for exposure of target portions C001 to C107 on the substrate W. The route R40 shows the relative movement between the substrate W and the fluid handling structure IH. The route, that R40 is an example of, may be referred to as the scanner exposure route.

In Figure 5, the target portions are exposed in the numbered order. A speed of the fluid handling structure IH relative to the substrate W may be referred to as an exposure scanning speed, or a scan/scanning speed. As used herein, the term "speed" refers to the scanning speed or exposure speed, i.e. the relative speed between the fluid handling structure IH and the substrate W as the fluid handling structure IH moves relative to the substrate W.

As above, the relative movement between the fluid handling structure IH and the substrate W may be caused by movement of the substrate support WT on which the substrate W is supported. Thus, the scanning speed of the fluid handling structure IH may be determined by the speed of the substrate support WT. Target portions depicted with dense hatching, e.g., C104, are edge target portions that are exposed at a low speed. Target portions depicted with light hatching, e.g., C085, are edge target portions that are exposed at a low speed, but faster than the densely hatched target portions. Edge target portions are exposed but the exposure motion covers only the part of the target portion that overlaps the substrate W, not the full length of the edge target portion. Route R40 has been calculated by attempting to optimize for throughput and includes long diagonal motions R41, R42. Diagonal motions R41, R42 are transfer moves between the exposure of a target portion at the end of one row and the exposure of the target portion at the beginning of the next. Diagonal motion R41 comes after exposure of edge target portion C104 and repositions the substrate W for exposure of edge target portion C105. Diagonal motion R42 comes after exposure of edge target portion C003 and repositions the substrate W for exposure of edge target portion C004.

It will be seen that this production route mostly consists of straight-line motions in the scan (+/-Y) or transverse (+/-X) directions. This measure, together with the described speed variations for selected edge portions, may be effective to reduce defects due to immersion liquid loss (watermarks) or bubbles becoming entrained in the immersion liquid. Other measures and other routes can be devised, but there is always a compromise to be determined between defectivity rate (rate of defects) and throughput.

The occurrence of and/or extent of the loss of immersion liquid from the confines of the fluid handling structure IH as the fluid handling structure IH moves relative to the surface of the substrate W may depend on several factors. The several factors may include factors relating to the nature of the relative movement between the fluid handling structure IH and the substrate W. For example, the several factors may include the scanning speed. The higher the scanning speed, the more likely is that immersion liquid will be lost from the confines of the fluid handling structure IH. The several factors may also include, for example, the acceleration of the fluid handling structure IH relative to the substrate W, or higher order derivatives of position with respect to time (e.g. jerk). The several factors may further include a direction in which the fluid handling structure IH moves relative to the surface of the substrate W. The several factors may further include, for example, a change in direction which occurs at some point during the moving of the fluid handling structure IH relative to the surface of the substrate W.

There may exist a critical scanning speed. Below the critical scanning speed, there may be very little loss of immersion liquid as the fluid handling structure IH moves over the substrate W. Above the critical scanning speed, there may be a relatively large amount of immersion liquid loss from the fluid handling structure IH as the fluid handling structure IH moves relative to the substrate W. The critical scanning speed may be dependent on various other factors relating to the fluid handling structure IH and/or the substrate W, some of which are discussed below.

The several factors may further include factors relating to the substrate W. For example, the several factors may include the properties of the photoresist which forms the surface of the substrate W, such as the wettability of the photoresist which forms the surface of a substrate W. The higher the wettability of the photoresist, the more likely that immersion liquid is lost from the confines of the fluid handling structure IH. Thus, the higher the wettability of the photoresist, the lower the critical scanning speed.

The several factors may further include, for example, factors relating to the fluid handling structure IH. For example, the several factors may include parameters of the operation of the fluid handling structure IH, such as a fly height (a distance between a lower surface of the fluid handling structure IH and the top surface of the substrate W), a flow-rate through a fluid extraction system of the fluid handling structure IH, and a flow-rate of the gas seal 16.

The several factors may further include, for example, a condition (i.e. health) of the fluid handling structure IH. Over time, fluid handling structure IH may become damaged. Damage to fluid handling structure IH may result in increased loss of immersion liquid as the fluid handling structure IH is moved relative to the surface of the substrate W. Damage to fluid handling structure IH may include, for example, blocked openings in immersion liquid supply/extraction systems (e.g. blocked openings in the system which forms the gas seal 16). Damage to fluid handling structure IH may also include, for example, scratches on surfaces of the fluid handling structure IH, e.g. scratches on the lower surface of the fluid handling structure IH (i.e. the surface of the fluid handling structure IH which faces the top surface of the substrate W). Another factor which relates to the condition/health of the fluid handling structure IH is contamination of the fluid handling structure IH. If the fluid handling structure IH (e.g. the lower surface thereof) becomes contaminated, a likelihood or extent of liquid loss from the liquid handling structure IH during movement of the fluid handling structure IH relative to the surface of the substrate W may be increased. Any deterioration in the condition/health of the fluid handling structure IH may lead to a decrease in the critical scanning speed.

Currently, immersion lithographic apparatuses may be operated with a relatively low scanning speed to reduce the risk of (and/or the extent of) the loss of immersion liquid during operation of the lithographic apparatus. This scanning speed may be fixed. That is, the scanning speed may not be adapted based on the several factors described above. Thus, for significant amounts of time, a scanning speed of the lithographic apparatus may be lower than necessary. Consequently, a throughput of the lithographic apparatus may be excessively low.

In some cases, there may be times at which the critical scanning speed becomes lower than the fixed scanning speed set for the lithographic apparatus. In such cases, continuing to run the lithographic apparatus would result in significant immersion liquid loss, and thus unacceptable defectivity. The critical scanning speed may become lower than the fixed scanning speed in cases where the fluid handling structure IH has become damaged, or when the type of photoresist used has a higher wettability than typical photoresists.

Considering the above, the present disclosure provides methods for evaluating one or more of the several factors described above, and/or for evaluating the effect of the one or more several factors on the loss of immersion liquid during the movement of the fluid handling structure IH relative to the top surface of the substrate W, or to assessing parameters that are related to the loss of immersion liquid from the fluid handling structure IH during movement of the fluid handling structure IH relative the surface of the substrate W. Parameters that are related to the loss of immersion liquid from the fluid handling structure IH during movement of the fluid handling structure IH relative the surface of the substrate W may be parameters that are associated with the fluid handling structure IH and/or the wettability of the substrate W. Some embodiments of the present disclosure are methods of determining the critical scanning speed. Based on the information obtained by the methods of the present disclosure, it may be possible to adapt parameters of the operation of the lithographic apparatus (e.g. the scanning speed) to maximise throughput without introducing defectivity. The methods described may be performed in a lithographic apparatus, for example, in a lithographic apparatus in a semiconductor fabrication plant. By performing the methods of the present disclosure in a lithographic apparatus in a semiconductor fabrication plant, the information obtained about the loss of immersion liquid is specific to the lithographic apparatus. Thus, the information may take into account factors which may differ between different lithographic apparatuses in different semiconductor manufacturing facilities, e.g. the health/condition of the fluid handling structure IH.

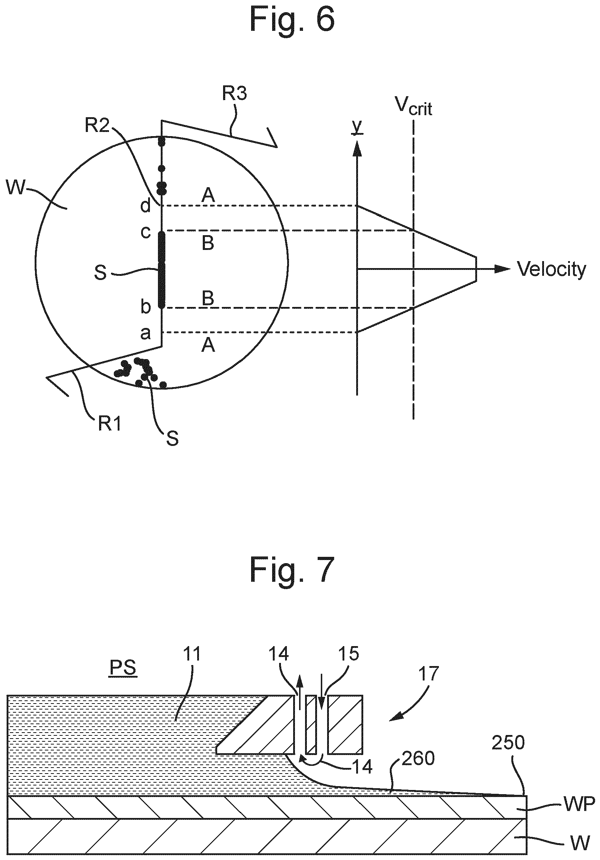

A first method of the present disclosure will now be described with reference to Figure 6. Figure 6 depicts a path (or route) comprising path portions (or route portions) R1, R2, R3 along which the fluid handling structure IH moves relative to the surface of the substrate W during execution of the first method.

In the first method, the path comprises a measurement path portion R2. A speed of fluid handling structure IH may vary over the measurement path portion R2 of the path. For example, the speed of the fluid handling structure IH relative to the substrate W may vary as a function of the position of the fluid handling structure IH relative to (i.e. with respect to) the substrate W. Additionally or alternatively, the speed of the fluid handling structure IH relative to the substrate W may vary as a function of time. In such embodiments, the position of the fluid handling structure IH relative to the substrate W may be known as a function of time, such that the speed of the fluid handling structure IH relative to the substrate W as a function of the position of the fluid handling structure IH relative to the substrate W can be determined or otherwise derived.

The first method further comprises inspecting a surface of the substrate W. The inspection of the surface of the substrate W may comprise identifying signs of fluid S in the surface of the substrate W. As used herein, the term "signs of fluid" S means any indication that fluid is present, or has previously been present, on the surface of the substrate W. Examples of signs of fluid on the substrate W may include liquid droplets on the surface of the substrate W. Examples of signs of fluid on the substrate W may also include bubbles on the surface of the substrate W. Examples of signs of fluid may also include marks that are formed on the surface of the substrate W by a droplet or bubble which has evaporated or has otherwise been removed from the surface of the substrate W. Such marks may be referred to as stains.

The signs of fluid S may also include defects in a pattern that has imparted the surface of the substrate W. Where immersion liquid has been lost from the fluid handling structure IH, a defect may be formed in the pattern which is imparted to the substrate W. Consequently, defects in the pattern imparted to the surface of the substrate W may be indicative of a location at which immersion liquid has been lost from the fluid handling structure IH.

The inspection of the surface of the substrate W may be performed after the movement of the fluid handling structure IH relative to the substrate W. For example, the inspection of the surface of the substrate W may be performed after the termination of the step of moving the fluid handling structure IH relative to the substrate W. In other embodiments, the inspection of the surface of the substrate W may be performed concurrently (i.e. simultaneously) with the movement of the fluid handling structure IH relative to the substrate W. Where the inspection of the surface of the substrate W is performed after step of moving the fluid handling structure IH relative to the substrate W, the inspection of the surface of the substrate W may comprise identifying signs of fluid S remaining on the substrate W after the movement of the fluid handling structure IH relative to the substrate W has terminated.

The first method further comprises determining a parameter. The parameter may be a parameter which is associated with the fluid handling structure IH. Alternatively, the parameter may be a parameter which is associated with the wettability of the substrate W (i.e. the wettability of the photoresist on the surface of the substrate W). Alternatively, the parameter may be associated with both the fluid handling structure IH and the wettability of the substrate W (i.e. the wettability of the photoresist on the surface of the substrate W). In some embodiments the parameter may be a parameter that is associated with other variables, i.e. with variables in addition to the fluid handling structure IH and/or the wettability of the substrate W. The determination of the parameter is based on the inspection of the surface of the substrate W.

In the first method, the parameter which is associated by the fluid handling structure IH and/or the wettability of the photoresist on the substrate W may be the critical scanning speed. The critical scanning speed may be determined based on the inspection of the surface of the substrate W, and in particular, based on the signs of fluid S identified on the surface of the substrate W. For example, the critical scanning speed may be determined based on the locations and/or density of signs of fluid S identified on the surface of the substrate W.

As depicted in Figure 6, the fluid handling structure IH and the substrate W are moved relative to one another such that the fluid handling structure IH moves across the surface of the substrate W along the path. The measurement path portion R2 of this path is substantially linear (i.e. straight, not curved and having no corners). The path depicted in Figure 6 further comprises portions R1 and R3. Path portions R1 and R3 are not be co-linear with the measurement path portion R2. Path portions R1 and R3 are provided to move the fluid handling structure IH into a position relative to substrate W which is appropriate to the measurement path portion R2 of the path to be initiated. As will be appreciated, path portions R1 and R3 are not essential to the method.

As the fluid handling structure IH moves along the measurement path R2, the speed of the fluid handling structure IH relative to the substrate W may be varied. On the right-hand side of Figure 6, a plot of the speed of the fluid handling structure IH relative to the substrate W against the position of the fluid handling structure IH relative to the substrate W is depicted. The plot is aligned with the path shown on the left-had side of Figure 6.

For example, over a first part of the measurement path portion R2, the speed of the fluid handling structure IH relative to the substrate W may increase. Over a second part of the measurement path portion R2 (which is after the first part of the measurement path portion R2), the speed of a fluid handling structure IH relative to the substrate W may decrease. There may be a portion of the measurement path portion R2 over which the speed of the fluid handling structure IH relative to the substrate W remains substantially constant. The portion of the measurement path R2 over which the speed of the fluid handling structure IH relative to the substrate W remains substantially constant may be between the first and second parts of the measurement path portion R2.

At the start (point "a" in Figure 6) of the measurement path portion R2 of the path, a speed of the fluid handling structure IH relative to the substrate W may be less than the critical scanning speed V_{crit}. Thus, as the fluid handling structure IH moves across the surface of the substrate W, the immersion liquid remains substantially confined to within the fluid handling structure IH, (and, in some cases, substantially no immersion liquid is lost from the fluid handling structure IH). Consequently, there are no signs of fluid S left on the surface of the substrate W.

At some point along the first portion of the measurement path portion R2 of the path (point "b" in Figure 6), the speed of the fluid handling structure IH relative to the substrate W increases to be above the critical scanning speed V_{crit}. At this point, immersion liquid begins to be lost from the fluid handling structure IH, resulting in immersion liquid remaining on the surface of the substrate W after the fluid handling structure IH has moved on along the path. Thus, from this point, signs of fluid S are present on the surface of the substrate W.

For as long as the speed of the fluid handling structure IH relative to the substrate W remains above the critical scanning speed, immersion liquid may continue to be lost from within the fluid handling structure IH.

At some point during the second part of the measurement path portion R2 of the path (point "c" in Figure 6), the speed of the fluid handling structure IH relative to the substrate W may decrease to be below the critical scanning speed V_{crit}. At this point, immersion liquid may cease to be lost from within the fluid handling structure IH. Thus, from this point, signs of fluid S are not present on the surface of the substrate W.

Considering the above, the critical scanning speed V_{crit} may be determined by considering the locations and/or density of signs of fluid S identified on the surface of the substrate W in conjunction with the speed of the fluid handling structure IH as a function of the position of the fluid handling structure IH.

More specifically, from the inspection of the surface of the substrate W, the location at which signs of fluid S begin to appear along the measurement path portion R2 (point "b" in Figure 6) can be identified. The speed of the fluid handling structure IH at the identified location can then be determined (e.g. from the known speed of the fluid handling structure IH as a function of position). The determined speed may be the critical scanning speed V_{crit}.

Additionally or alternatively, from the inspection of the surface of the substrate W, the location at which signs of fluid S cease to appear along the measurement path portion R2 (point "c" in Figure 6) can be identified. The speed of the fluid handling structure IH at the identified location can then be determined (e.g. from the known speed of the fluid handling structure IH as a function of position).

In some cases, there may be a certain amount of immersion liquid lost from the fluid handling structure IH even when the fluid handling structure IH is moving with a speed that is below the critical scanning speed V_{crit}. When the fluid handling structure IH moves relative to the substrate with a speed that is greater than the critical scanning speed V_{crit}, the amount of immersion liquid lost from the fluid handling structure IH may markedly increase. In view of this, the identification of the location at which signs of fluid S begin to appear along the measurement path portion R2 (point "b" in Figure 6) may comprise determining the location at which the incidence of the signs of fluid S and/or the density of the signs of fluid S exceed a predetermined threshold. Similarly, the identification of the location at which signs of fluid S cease to appear along the measurement path portion R2 (point "b" in Figure 6) may comprise determining the location at which the incidence of the signs of fluid S and/or the density of the signs of fluid S fall below the predetermined threshold. The predetermined threshold may be of the form "number of signs of fluid S per unit distance", for example.

While the embodiment depicted in Figure 6 shows a substantially linear (i.e. straight-line) measurement path portion R2 of the path, this is not essential. The measurement path portion R2 of the path may comprise one or more changes of direction i.e. corners. The measurement path portion R2 of the path may be a meandering path such as the path depicted in Figure 5.

Over the course of measurement path portion R2 of the path, the speed of the fluid handling structure IH relative to substrate W may be varied from substantially 0 to the maximum operating speed of the fluid handling structure IH relative to the substrate W (which may be limited by the speed with which the substrate support WT can be moved). By varying this speed over this full range, it can be ensured that the critical scanning speed V_{crit} is identified (if a critical scanning speed exists within the operating speed range of the lithographic apparatus).

In some cases, the critical scanning speed V_{crit} may be different for different directions of movement of the fluid handling structure IH relative to the substrate W. Consequently, the method of determining critical scanning speed V_{crit} described above may be performed several times (e.g. two, three, four, more times). Each time the method of determining critical scanning speed V_{crit} is performed, the direction of the movement of the fluid handling structure IH relative to the substrate W may be different. That is, there may be a first movement of the fluid handling structure IH relative to substrate W, in which the fluid handling structure IH is moved relative to the substrate W in a first direction. During that first movement, the speed of the fluid handling structure IH relative to substrate W may be varied, as described above. The method may also comprise a second movement of the fluid handling structure IH relative to the substrate W. The second movement may be in a second direction relative to the substrate W. The second direction may be different to the first direction. This may be repeated for a third movement, fourth movement, fifth movement, etc.

The method may further comprise one or more inspection steps, in which the surface of the substrate W is inspected to identify signs of fluid thereon. From the signs of fluid S identified, a critical scanning speed for the first direction may be determined, and a critical scanning speed for the second direction may be determined.

When the method comprises several movement steps, there may be an inspection step that is performed after each movement step. That is, the method may comprise: performing the first movement; then performing a first inspection of the surface of the substrate W performed; then performing a second movement; and then performing a second inspection of the substrate W. Alternatively, inspection of the surface of the substrate W may be performed after several movements steps have been performed. That is, the method may comprise: performing the first movement; then performing the second movement; and then performing an inspection of the surface of the substrate W. In the latter example, the inspection of the surface of the substrate W comprise identifying signs of fluid S which result from loss of immersion liquid from the fluid handling structure IH during both the first movement and second movement.

In some cases, the critical scanning speed V_{crit} may be different in different areas across the surface of the substrate W. Thus, the first method may be repeated in different areas of the surface of the substrate W to determine critical scanning speeds for the different areas of the surface of the substrate W.

The first method described above provides an accurate way of determining critical scanning speed V_{crit}. Further, the first method takes into account factors that are specific to the lithographic apparatus on which the first method is performed. For example, the first method takes into account the specific nature of the fluid handling structure IH being used (i.e. type, flow conditions and any damage thereof), and also the specific nature of the photoresist on the substrate W. Consequently, the critical scanning speed V_{crit} determined may be accurate for the lithographic apparatus is performed (e.g. more accurate than standard critical scanning speed measurements performed on different lithographic apparatuses).

A second method of the present disclosure will now be described with reference to Figures 7 to 10. Like the first method, the second method comprises determining a parameter associated with the fluid handling structure IH and/or the photoresist on the substrate W. The parameter is determined based on signs of fluid S identified on the surface of the substrate W by inspecting the surface of the substrate W. The signs of fluid S arise from immersion liquid that is lost from the fluid handling structure IH during a movement of the fluid handling structure IH relative to the substrate W.

In the second method, the movement of the fluid handling structure IH relative to the substrate W comprises moving the fluid handling structure IH over a fluid-pinning feature. The fluid-pinning feature may be referred to as a meniscus-pinning feature. The fluid-pinning feature may be any feature which is configured to pin (i.e. hold or attach) a meniscus of the immersion liquid confined within the fluid handling structure IH as the fluid handling structure IH passes over the fluid-pinning feature.

The fluid-pinning feature may be a topological feature on the surface of the substrate W. For example, the fluid-pinning feature may be a ridge on the surface of the substrate W. Additionally, or alternatively, the fluid-pinning feature may be a change in the wettability of the surface of the substrate W. For example, the fluid-pinning feature may be a boundary between a first surface portion with a first wettability and a second surface portion with a second wettability (where the second wettability is different to the first wettability). Additionally or alternatively, the fluid-pinning feature may be a boundary between one component and another component (e.g. between the substrate W and the cover ring 101). The boundary between one component and another component may be a fluid-pinning feature because of the topology of the boundary (e.g. a change in height) and/or a change in wettability over the boundary.

Figure 7 depicts film-pulling of a fluid handling structure IH moving over a substrate W. Specifically, the substrate W is moving in the rightward direction relative to the fluid handling structure IH (so the fluid handling structure IH is moving in the leftward direction relative to the substrate W). When the fluid handling structure IH moves over a fluid-pinning feature, film-pulling may occur. In Figure 7, the right-hand edge of the substrate W forms the fluid-pinning feature 250.

Figure 7 shows a point in time at which a trailing (or receding) edge of the fluid handling structure IH has passed over the fluid-pinning feature 250 (the right-hand edge of the substrate W) and is moving radially inward towards the centre of the substrate W. As the trailing edge of the fluid handling structure IH passes over the fluid-pinning feature 250, a meniscus of immersion liquid is pinned at the fluid-pinning feature 250. As the fluid handling structure IH moves radially inward (leftward) relative to the substrate W, a film 260 of immersion liquid is pulled by the fluid handling structure IH. The film 260 of immersion liquid extends between the fluid-pinning feature 250 and the main pool of immersion liquid 11 confined within the fluid handling structure IH.

Over time, the film 260 of immersion liquid may break up into a plurality of droplets of immersion liquid that remain on the surface of the substrate W. Such droplets may result in signs of fluid S, as have been described above.

As will be described in further detail below, characteristics (e.g. the pattern) of immersion liquid remaining on the surface of the substrate W after film pulling depicted in Figure 7 can be used to determine a parameter that is associated with the fluid handling structure IH and/or the wettability of the photoresist on the surface of the substrate W.

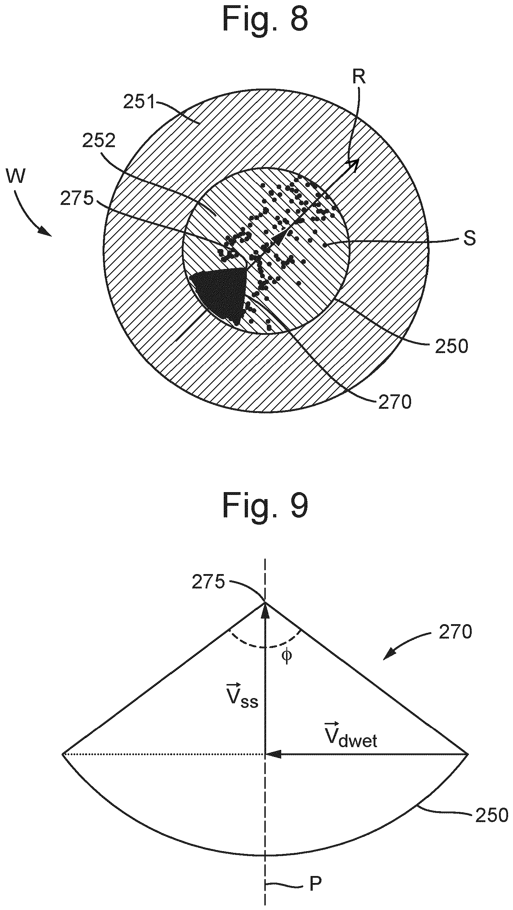

Figure 8 depicts the path R of a fluid handling structure IH over the surface of the substrate W during an example of the second method. The substrate W may be a substrate which is specifically configured for the second method to be performed. The surface of the substrate W depicted in Figure 8 comprises an outer portion 251 and an inner portion 252. The outer portion 251 is an annular portion. The outer portion 251 is radially outward of the inner portion 252 such that a boundary is formed between the outer portion 251 and the inner portion 252. An inner boundary of the outer portion 251 is the same as an outer boundary of the inner portion 252. It will be appreciated that the second method is not limited to being implemented with a substrate W having this particular geometry. Generally, any boundary between areas having different wettabilities would produce the fluid-pinning feature 250 required for the second method.

A wettability of the outer portion 251 may be different to a wettability of the inner portion 252. That is, the outer portion 251 may have a first wettability and the inner portion 252 may have a second wettability, where the second wettability is different to the first wettability. Consequently, the boundary between the outer portion 251 and the inner portion 252 may be a fluid-pinning feature 250.

The outer portion 251 of the surface of the substrate W may be formed of a different material to the inner portion 252 of the surface of the substrate W. In some embodiments, the first portion 251 of the surface of the substrate W may be formed of material from which the body of the substrate W is formed. This main body of the substrate W may be formed from, for example, silicon. Alternatively, the outer portion 251 of the surface of the substrate W may be formed from a coating applied to the main body of the substrate W, where the coating is different to the photoresist on the substrate W. The coating which is different to the photoresist may be, for example, hexamethyldisilazane (HMDS). The inner portion 252 of the surface of the substrate W may be formed from the layer of photoresist on the substrate W.

The substrate W depicted in Figure 8 may be manufactured by depositing a layer of photoresist over substantially all of the surface of the substrate W (i.e. over the outer portion 251 and the inner portion 252 of the surface of the substrate W), and then removing the photoresist from a portion of the surface of the substrate W to form the outer portion 251 of the surface of the substrate W.

In some embodiments, the outer and inner portions 251, 252 may be formed of the same material, and the difference in wettability between the outer and inner portions 251, 252 may be caused by applying a surface treatment. For example, the outer and inner portions 251, 252 may be formed by the layer of photoresist, and one of the outer and inner portions 251, 252 may be exposed to UV light to change the wettability of that portion, thus forming the fluid-pinning feature 250 at the boundary between the outer and inner portions 251, 252.

In the second method, the fluid handling structure IH may be moved relative to the substrate W along a path R such that the fluid handling structure IH crosses the boundary, i.e., the fluid-pinning feature 250, between the outer portion 251 of the surface of the substrate W and the inner portion 252 of the surface of the substrate W. In the second method, the scanning speed may remain constant as the fluid handling structure IH is moved relative to the substrate W along the path R. The fluid handling structure IH may cross the boundary between the outer and inner portions 251, 252 of the surface of the substrate W in a crossing direction. The crossing direction is indicated by the arrow in Figure 8. (I do not see the arrow.)

As the fluid handling structure IH moves over the boundary, i.e., the fluid-pinning feature 250, between the outer and inner portions 251, 252 of the surface of the substrate W, a meniscus of immersion liquid is pinned at the boundary between the outer and inner portions 251, 252 of the surface of the substrate W. The width of the pinned meniscus along the boundary between the outer and inner portions 251, 252 may be substantially the same as a diameter of an internal volume of the fluid handling structure IH.

After crossing the boundary, i.e., the fluid-pinning feature 250, between the outer and inner portions 251, 252 of the surface of the substrate W, the fluid handling structure IH continues to move in the crossing direction. By continuing to move in a crossing direction, the fluid handling structure IH pulls a thin film of immersion liquid in the crossing direction. As the fluid handling structure IH pulls the thin film of fluid in the crossing direction, the width (which may be a dimension substantially perpendicular to the crossing direction) of the film of immersion liquid may decrease. The width of the film may continue to decrease as the fluid handling structure IH moves in the crossing direction until the width becomes substantially 0. Consequently, thin film that is pulled by the fluid handling structure IH may be substantially triangular. Thus, the signs of fluid S that arise from the film-pulling described above may be arranged in a triangular arrangement/pattern 270, as shown in Figure 8. The triangular arrangement/pattern 270 may be an example of a fluid-loss pattern.

The triangular fluid-loss pattern may have a terminating vertex 275 at the point at which the width of the film pulled by the fluid handling structure IH becomes 0. That is, the terminating vertex 275 of the triangular fluid-loss pattern may be a vertex of which is separated from the fluid-pinning feature 250 in the crossing direction. In the example depicted in Figure 8, the terminating vertex 275 of the triangular fluid-loss pattern is the vertex which is separated from the boundary between the outer portion 252 of the surface of the substrate W and the inner portion 252 of the surface of the substrate W.

In the second method, the inspection of the surface of the substrate W may comprise identifying a fluid-loss pattern (e.g. a triangular arrangement/pattern 270 of signs of fluid S on the surface of the substrate W) from signs of fluid S remaining on the surface of the substrate W. From the fluid-loss pattern, the parameter associated with the fluid handling structure IH and/or the wettability of the substrate W may be determined.

The parameter associated with the fluid handling structure IH and/or the wettability of the substrate W may be a de-wetting velocity, or another parameter derived from the de-wetting velocity. The de-wetting velocity may be a property that is primarily dependent on the wettability of the inner portion 252 of the surface of the substrate W. The de-wetting velocity may determine the rate at which the width of the film pulled by the fluid handling structure IH decreases.

Figure 9 depicts a triangle which may be obtained from the triangular arrangement/pattern 270 on the surface of a substrate W (e.g. based on the inspection of the surface of the substrate W). The terminating vertex 275 may have an angle, ϕ. From the inspection of the surface of the substrate W, it may be possible to determine (e.g. measure) the angle, ϕ.

The parameter associated with the fluid handling structure IH and/or the wettability of the substrate W (e.g. the de-wetting velocity) may be determined based on the angle, ϕ. For example, the angle, ϕ, may be a function of the scanning speed of the fluid handing structure Vss the de-wetting velocity V_{dwet}. As the angle, ϕ, is known (because it is measured during, or based on, the inspection of the surface of the substrate W) and the scanning speed Vss is known (because the scanning speed is controllable), it is possible to determine the de-wetting velocity V_{dwet} from the triangular fluid-loss pattern. Further detail on this is discussed in COX, R. G., 1986, "The dynamics of the spreading of liquids on a solid surface", Part 1, Viscous flow, J. Fluid Mech. 168, 169-194, the entirety of which is hereby incorporated by reference.

In some embodiments, the de-wetting velocity V_{dwet} may be the ultimate parameter which is determined as part of the second method. Additionally or alternatively, the de-wetting velocity V_{dwet} may be used to determine a critical scanning speed for the type of photoresist that forms the inner portion 252 of the substrate W. There may be a substantially linear relationship between the critical scanning speed and the de-wetting speed, i.e. V_{crit} = A * V_{dwet} (where V_{crit} is the critical scanning speed). The constant, A, may be dependent on various factors, such as the shape of the fluid handling structure IH, the health/condition of the fluid handling structure IH, flow settings, etc.

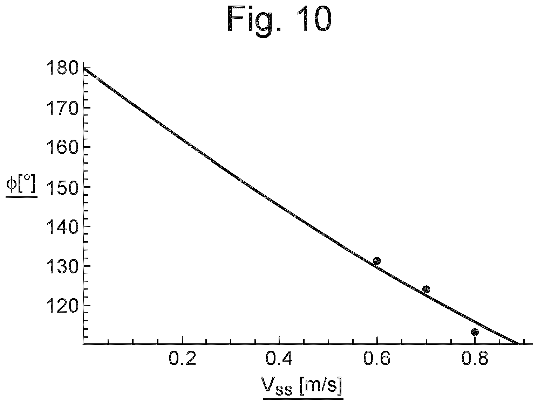

To accurately determine the de-wetting velocity v_{dwet} for a given type of photoresist, the method described above may be repeated at various different scanning speeds. Figure 10 depicts a plot of the angle ϕ of the terminating vertex 275 against the scanning speed. From the gradient of this plot, an accurate value for the de-wetting velocity v_{dwet} can be determined.

The second method has been described above primarily in relation to a substrate W having a surface with two portions having different wettabilities to form a fluid-pinning feature 250 at the boundary therebetween. However, the second method may be performed using any fluid-pinning feature, such as a topological feature on the surface of the substrate W, or by using the edge of the substrate W as the fluid-pinning feature.

The de-wetting velocity v_{dwet} (and any critical scanning speed determined therefrom) may be a function of the properties of photoresist (i.e. the wettability of the photoresist), and may be affected by the properties of the fluid handling structure IH to a lesser extent. Thus, from the second method, it may be possible to derive maximum scan speeds that apply generally for different types of photoresist.

By performing the second method with a variety of different photoresists, it may be possible to compile a list a standard critical scanning speeds V_{crit} for different types of photoresist. This list of photoresists may be provided to different lithographic apparatuses in different locations. These lithographic apparatuses may be configured to change the maximum operating scanning speed based on the type of photoresist on the substrate W that is being exposed. The type of photoresist may be input to the lithographic apparatus by a user. Alternatively, the lithographic apparatus may be configured to determine the type of photoresist on the substrate W in some sort of measurement step.

In some embodiments, the second method may be performed several times at different locations on the surface of the substrate W. That is, as part of the second method, the fluid handling structure IH may pass over the fluid-pinning feature 250 two, three, four or more times. The fluid handling structure IH may pass over the fluid-pinning feature 250 at a different location at each time. The parameter determined as part of the second method may be determined for each crossing of the fluid-pinning feature 250.

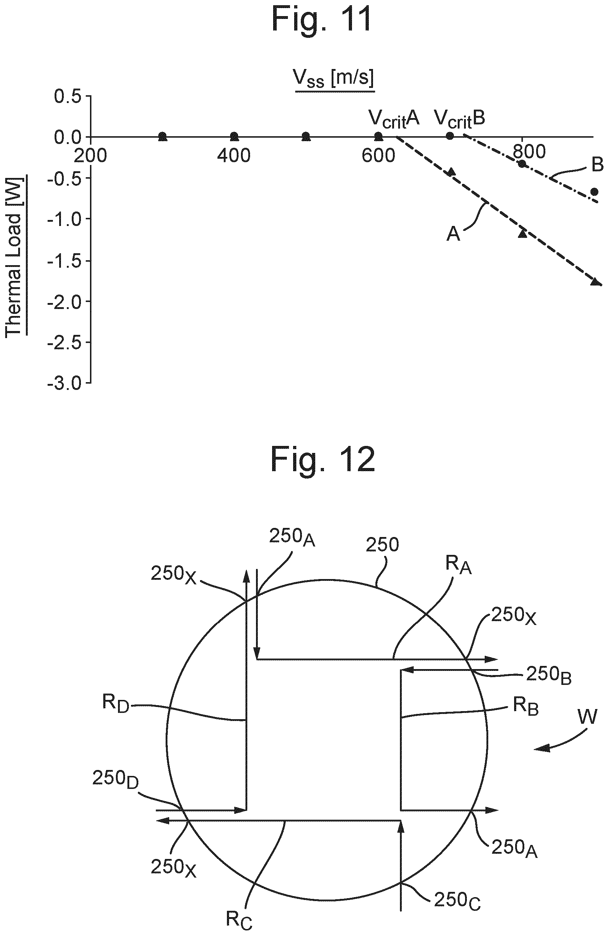

For example, the substrate W may be divided into four quadrants, and the fluid handling structure IH may pass over a fluid-pinning feature 250 in each of the four quadrants. In some examples, the fluid handling structure IH may pass over the edge of the substrate W in each of the four quadrants. An example of this is depicted n Figure 12. As shown in Figure 12, there are four movements P_{A}, P_{B}, P_{C}, P_{D} of the fluid handling structure IH relative to the substrate W. During each of the movements P_{A}, P_{B}, P_{C}, P_{D}, the fluid handling structure IH crosses the edge of the substrate W when moving towards the substrate W (see 250_{A}, 250_{B}, 250_{C}, 250_{D}). The fluid handling structure IH may also cross the edge of the substrate W when moving away from the substrate (see 250x).

In various methods of the present disclosure, such as the first method and the second method, the inspection of the surface of the substrate W may be performed using any means or technique which allows for signs of fluid S to be identified, quantified, evaluated, or otherwise assessed. In some embodiments, the inspecting the surface of the substrate W by imaging the surface of the substrate W. From the image of the surface of the substrate W, it may be possible to identify the signs of fluid S (e.g. fluid droplets, fluid bubbles, marks or stains, etc).

The imaging of the surface of the substrate W may comprise use of any suitable imaging means. For example, the imaging of the surface of the substrate W may be performed using an optical camera. For increased resolution, (and, therefore, the ability to identify smaller signs of fluid S) an optical microscope may be used to image the surface of the substrate W. Optical bright-filed microscopy might be a preferred technique if the surface of the substrate W is to be imaged using an optical microscope.

In some embodiments, the imaging of the surface of the substrate W may comprise use of a charged particle inspection apparatus, such as a scanning electron microscope (SEM). Use of an SEM may be advantageous where the signs of fluid S that are to be identified are defects in the pattern imparted to the surface of the substrate W. This may be because the defects in the pattern imparted to the surface of the substrate W are too small to be imaged using optical inspection means.

In some embodiments, the inspecting of the surface of the substrate W may comprise obtaining a height map of the surface of the substrate W. In this context a "height map" refers to a data describing the height (i.e. position in the z-direction) of the surface of the substrate W as a function of the position in the horizontal (x/y) plane. Regions of the height map where the height of the substrate W differs from an average height of the surface of the substrate W may be indicative of a sign of fluid S. In some embodiments, the height map of the surface of the substrate W may be obtained using a level sensor. The level sensor may be an ultra-violet (UV) level sensor.

In some embodiments, the inspecting of the surface of the substrate W may comprise use of scatterometry.

In accordance with the present disclosure, the inspecting of the surface of the substrate W may be performed by inspection means (i.e. sensors, sensor systems or measurement systems) which is/are in the lithographic apparatus itself. By inspecting the surface of the substrate W with inspection means within the lithographic apparatus itself, it may be possible to assess the immersion liquid lost from the fluid handling structure IH relatively quickly (compared to a method in which inspection of the substrate W is performed outside of the lithographic apparatus, e.g. using an external metrology tool).

Some lithographic apparatuses may comprise a measurement station and an exposure station. The exposure station may be a station at which the substrate W is exposed. The measurement station may be a station at which preparatory measures (e.g. measurements, alignment etc) are performed on a substrate W before that substrate W is moved to the exposure station. The inspection means used for performing the methods of the present disclosure may be inspection means within the measurement station or the exposure station. It may be preferable for the inspection means to be within the exposure station. This is because the movement of the fluid handling structure IH relative to the substrate W may be performed at the exposure station. Thus, by also performing the inspection of the surface of the substrate W, at the exposure station, the time taken for the method to be performed is reduced (because there is no time required to transport the substrate W from the exposure station to the measurement station).

A third method of the present disclosure comprises measuring or otherwise evaluating the amount of immersion liquid lost from a fluid handling structure IH based on an evaporative cooling load exerted on the substrate W as a result of the immersion liquid lost from a fluid handling structure IH.

When immersion liquid is lost from confines of the fluid handling structure IH during movement of the fluid handling structure IH relative to a substrate W, the fluid remaining on the surface of the substrate W may evaporate over time. The evaporation of fluid from the surface of the substrate W may apply an evaporative thermal load (i.e. a cooling load) on the surface of the substrate W. It may be possible to assess the magnitude of this evaporative cooling load, and as a result, determine a volume of immersion liquid that is lost from the confinement of the fluid handling structure IH during a movement of the fluid handling structure IH relative to the substrate W.

The evaporative thermal load on the substrate W as a result of immersion liquid evaporating from the surface of the substrate W may be determined through a variety of means. For example, the evaporative thermal load on the substrate W may be determined using measurements made by one or more temperature sensors integrated in the substrate W. The evaporative thermal load exerted on the substrate W may be determined based on measuring the change in temperature of the substrate W during, and/or after, the time over which the fluid handling structure IH passes over the surface of the substrate W.

In some embodiments, the evaporative thermal load experienced by the substrate W may be passed onto the substrate support WT (i.e. by conduction between the substrate W and the substrate support WT). Thus, the evaporative thermal load exerted on the substrate W may be measured indirectly by measuring the thermal load on the substrate support WT. The thermal load on the substrate support WT may be measured by one or more temperature measuring means in the substrate support WT.

The temperature measuring means in the substrate support WT may comprise one or more temperature sensors in the substrate support WT. The one or more temperature sensors may be configured to measure a temperature of a main body of the substrate support WT.

The substrate support WT may comprise one or more heating elements configured to regulate the temperature of a substrate support WT. Each of these heating elements may comprise an integrated temperature sensor. The integrated temperature sensors of the heating elements may be used as the temperature measuring means referred to above.

The temperature measuring means in the substrate support WT may comprise temperature measuring means configured to measure a temperature of conditioning fluid within conditioning channel(s) 161 of the substrate support WT. In cases where there is no evaporative thermal load exerted on the substrate W, conditioning fluid leaving the substrate support WT after flowing through the conditioning channel(s) 161 of the substrate support WT may have a known temperature. When an evaporative load is applied to the surface of the substrate W (i.e. by immersion liquid that is lost from the confines of the fluid handling structure IH), the resulting thermal load on substrate support WT may mean that more heat is transferred from the conditioning fluid to the substrate support WT. Thus, the temperature of the conditioning fluid leaving the substrate support WT after flowing through the conditioning channel(s) 161 of the substrate support WT may be less than said known temperature. The temperature difference between said known temperature and the measured temperature of the conditioning fluid leaving the substrate support WT can be attributed to the evaporative thermal load exerted on the substrate W as a result of immersion liquid lost from the fluid handling structure IH.

From the amount of immersion liquid lost from the fluid handling structure IH (which is determined based on an evaporative thermal load exerted on the substrate W), a parameter associated with the fluid handling structure IH and/or the wettability of the substrate W may be obtained.

In one method, the technique of determining a magnitude (e.g. volume) of immersion liquid lost from the fluid handling structure IH based on the evaporative thermal load is used to determine the critical scanning speed. In accordance with this method, a plurality of movements of the fluid handing structure IH relative to the substrate W are performed. Each one of the plurality of movements may be performed at a constant speed. The constant speed for each of the plurality of movement may be different, i.e. such that the plurality of movements are each performed at a different speed. That is, there may be a first movement of the fluid handling structure IH relative to the substrate W performed at a first speed, a second movement of the fluid handling structure IH relative to the substrate W performed at a second speed, a third movement of the fluid handling structure IH relative to the substrate W performed at a third speed, etc. For each of the plurality of movements, the evaporative thermal load on the substrate W may be determined.

Figure 11 depicts a plot of scanning speed of horizontal axis (i.e. the speed with which the fluid handling structure IH is moved relative to the substrate W) and thermal load on the vertical axis. The plot depicted in Figure 11 may be the result of performing a plurality of movements of the fluid handling structure IH relative to the substrate W in the manner described above. The plot depicted in Figure 11 comprises two series A, B for two different types of photoresist.

For series A, when the scan speed is low (e.g. less than 600mm per second), there is substantially no evaporative thermal load exerted on the substrate W. From this, it can be determined that the scan speed is below the critical scanning speed V_{crit}. Above 600mm per second, as the scan speed is increased, the evaporative thermal load exerted on the substrate W increases. Thus, it can be determined that the critical scanning speed V_{crit} is approximately 600mm per second.

A similar pattern is exhibited for series B. However, the critical scanning speed V_{crit} for the photoresist corresponding to series B is higher than the critical scanning speed V_{crit} for the photoresist corresponding to series A.

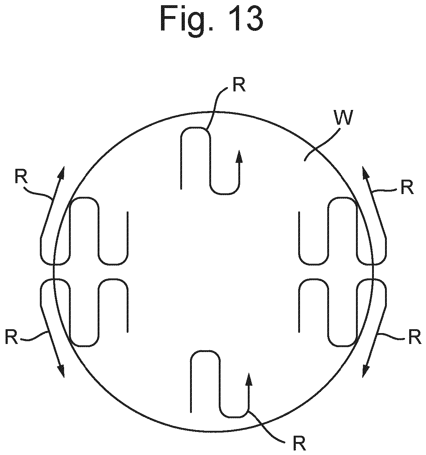

Figure 13 depicts a plurality of paths R of a fluid handling structure IH relative to a substrate W. In a method according to the present disclosure, the fluid handling structure IH may be moved relative to the substrate W over the plurality of paths R, and then the surface of the substrate W may be inspected to identify signs of fluid S. Each of the paths R depicted in Figure 13 may comprise one or more critical moves. A critical move may be a move of the fluid handling structure IH relative to the substrate W which is likely to lead to defectivity (e.g. a move of the fluid handling structure IH relative to the substrate W which is likely to lead to the loss of immersion liquid from the confines of the fluid handling structure IH). In some embodiments, the one or more critical moves may be a part of an exposure routing, such as that depicted in Figure 5. Critical moves within an exposure routing may comprise crossing the edge of the substrate W. Critical moves within an exposure routing may also comprise following the exposure routing at particular speeds and or with particular operating conditions for the fluid handling structure IH.

The substrate W depicted in Figure 13 may be divided into four quadrants. Identical moves (i.e. identical paths R) may be repeated in each of the four quadrants. For example, the fluid handling structure IH may cross the edge of the substrate W in each of the four quadrants of the substrate W. This may allow the performance of the fluid handling structure IH and/or the substrate support WT to be determined locally.

During any of the methods of the present disclosure, one or more operating conditions of the fluid handling structure IH may be increased so as to adapt how readily immersion liquid is lost from the fluid handling structure IH. By adapting the operating conditions of the fluid handling structure IH such that immersion liquid is more likely to be lost from the fluid handling structure IH, it may be easier to obtain data relating, e.g. how different photoresists compare to one another with regards to their relative critical scanning speeds. The operating conditions that may be varied may include the fly height (the distance between the fluid handling structure IH and the surface and the substrate W). Increasing the fly height may increase the likelihood of fluid loss from the fluid handling structure IH. Other operating conditions may include the flow rate of a fluid extraction system of the fluid handling structure IH and a flow rate of the gas seal 16.

The parameter that is determined by any of the methods described herein may be used in the control of the lithographic apparatus. In particular, the parameter may be used to determine the scan speed used during operating of the lithographic apparatus. For instance, where the parameter determined is a critical scanning speed, the scanning speed during operation of the lithographic apparatus may be made to be close to, but less than, the critical scanning speed. This is as opposed to continuously operating the lithographic apparatus at a conservative, slow scan speed. The scan speed that the lithographic apparatus is operated at may be greater than the conservative, slow scan speed typically employed and less than the determined critical scanning speed. Thus, throughput of the lithographic apparatus can be increased without risking the introduction of defectivity into the patterns imparted with the substrate W.

In any of the methods described above, a deviation in a parameter (i.e. a parameter determined by any of the method described herein) from a standard value (e.g. a sudden worsening in the parameter) may be indicative of the presence of a fault or anomaly in the operation of the fluid handling structure IH. Based on the identification of this fault, a notification may be sent that maintenance is required or maintenance will be required in a specified period of time.

After performing methods of the present disclosure, it may be determined that the actual critical scanning speed is lower than the critical scanning speed being used in the lithographic apparatus. This may occur where, for example, due to significant damage to the fluid handling structure IH. In current systems (that is, before the present invention) when such a determination is made, production of substrate W with a lithographic apparatus may be ceased until the replacement fluid handling structure IH is installed. However, using the method of the present disclosure, it may be possible to accurately determine the new critical scanning speed, and to continue to operate the lithographic apparatus at a safe scanning speed that is less than the new critical scanning speed. Consequently, the lithographic apparatus can continue to be operated (with the damaged fluid handling structure IH) at the safe scanning speed until the fluid handling structure IH can be repaired/replaced. Thus, downtime of the lithographic apparatus is reduced.

Embodiments may provide a lithographic apparatus. The lithographic apparatus may have any/all of the other features or components of the lithographic apparatus as described above. For example, the lithographic apparatus may optionally comprise at least one or more of a source SO, an illumination system IL, a projection system PS, a substrate support WT, etc..

Specifically, the lithographic apparatus may comprise the projection system PS configured to project the radiation beam B towards the region of the surface of a substrate W. The lithographic apparatus may further comprise the substrate support WT as described in any of the above embodiments and variations.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc..

Where the context allows, embodiments of the invention may be implemented in hardware, firmware, software, or any combination thereof. Embodiments of the invention may also be implemented by instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g., carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described.

### Embodiments include the following numbered clauses:

1. A method for a lithographic apparatus comprising a fluid handling structure, wherein the fluid handling structure is configured to confine a fluid to a region of a surface of a substrate, and the method comprises:
   causing a movement of the fluid handling structure relative to the substrate, wherein a speed of the fluid handling structure relative to the substrate during the movement varies as a function of the position of the fluid handling structure relative to the substrate;
   inspecting the surface of the substrate; and
   determining a parameter associated with the fluid handling structure and/or the wettability of the substrate based on the inspecting of the surface of the substrate.
2. The method of clause 1, wherein the inspecting of the surface of the substrate comprises identifying signs of fluid on the surface of the substrate.
3. The method of clause 2, wherein the inspecting of the surface of the substrate comprises identifying signs of fluid remaining on the surface of the substrate after the movement of the fluid handling structure relative to the substrate.
4. The method of any of clauses 1 to 3, wherein the signs of fluid on the substrate comprise one or more of:
   fluid droplets on the surface of the substrate;
   bubbles on the surface of the substrate;
   marks or stains on the surface of the substrate by a fluid droplet or bubble; and
   defects in a pattern imparted to the surface of the substrate.
5. The method of any of the preceding clauses, wherein the substrate comprises a layer of photoresist, and the surface of the substrate is a surface of the layer of photoresist.
6. The method of any of the preceding clauses, wherein the parameter is a critical scanning speed, and the critical scanning speed is a speed of the fluid handling structure relative to the substrate above which fluid is lost from the fluid handling structure.
7. The method of any of the preceding clauses, wherein the causing the movement of the fluid handling structure relative to the substrate is such that the fluid handling structure moves across the surface of the substrate along a path.
8. The method of clause 7, further comprising identifying a critical point on the path, wherein the critical point is a point at which the incidence of signs of fluid on the surface of the substrate exceeds a threshold.
9. The method of clause 8, wherein the critical scanning speed is determined based on the identified critical point.
10. The method of any of clauses 7 to 9, wherein the path is linear.
11. The method of any of clauses 7 to 9, wherein the path comprises one or more corners, optionally wherein the path is a meandering path.
12. The method of any of the preceding clauses, wherein, during the movement of the fluid handling structure relative to the substrate, the speed of the fluid handling structure relative to the substrate increases from a first speed to a second speed and/or decreases from a second speed to a first speed.
13. The method of clause 12, wherein the second speed is a maximum speed of the fluid handling structure relative to the substrate.
14. The method of any of the preceding clauses, wherein the method comprises:
   causing a first movement of the fluid handling structure relative to the substrate in a first direction, wherein a speed of the fluid handling structure relative to the substrate varies as a function of the position of the fluid handling structure relative to the substrate;
   performing a first inspection of the surface of the substrate;
   determining a first parameter associated with the fluid handling structure and/or the wettability of the substrate based on the first inspection of the surface of the substrate;
   causing a second movement of the fluid handling structure relative to the substrate in a second direction, wherein a speed of the fluid handling structure relative to the substrate varies as a function of the position of the fluid handling structure relative to the substrate, and
   wherein the second direction is different to the first direction;
   performing a second inspection of the surface of the substrate;
   determining a second parameter associated with the fluid handling structure and/or the wettability of the substrate based on the second inspection of the surface of the substrate.
15. A method for a lithographic apparatus comprising a fluid handling structure, wherein the fluid handling structure is configured to confine a fluid to a region of a surface of a substrate, and the method comprises:
   causing a movement of the fluid handling structure relative to the substrate, wherein the fluid handling structure passes over a fluid-pinning feature during the movement of the fluid handling structure relative to the substrate;
   inspecting the surface of the substrate; and
   determining a parameter associated with the fluid handling structure and/or the wettability of the substrate based on the inspecting of the surface of the substrate.
16. The method of clause 15, wherein the fluid-pinning feature comprises a change in a wettability of a surface and/or a topological feature on the surface of the substrate.
17. The method of clause 15 or 16, wherein the fluid-pinning feature is an edge of the substrate.
18. The method of any of clauses 15 to 17, wherein the fluid-pinning feature is a boundary between an edge of the substrate and a cover ring, wherein the cover ring is disposed radially outward of the substrate.
19. The method of clause 15 or 16, wherein the fluid-pinning feature is a boundary between a first portion of the surface of the substrate and a second portion of the surface of the substrate, wherein the first portion of the surface of the substrate has a different wettability to the second portion of the surface of the substrate.
20. The method of clause 19, wherein the substrate comprises a layer of photoresist, and the second portion of the surface of the substrate is formed by the layer of photoresist.
21. The method of clause 19 or 20, wherein the substrate comprises a main body and a layer of photoresist, wherein the first portion of the surface of the substrate is formed by the main body, optionally wherein the first portion of the surface if formed by removing photoresist from the main body.
22. The method of clause 20, wherein the first portion of the substrate is formed by a coating on the main body, wherein the coating is different to the photoresist, optionally wherein the coating comprises hexamethyldisilazane.
23. The method of any of clauses 19 to 22, wherein the second portion of the substrate is a circular portion in a radial centre of the substrate, and the first portion is an annular portion radially outward of the first portion.
24. The method of any of clauses 15 to 23, wherein the inspecting of the surface of the substrate comprises identifying signs of fluid on the surface of the substrate.
25. The method of any of clauses 15 to 24, wherein the inspecting of the surface of the substrate comprises identifying signs of fluid remaining on the surface of the substrate after the movement of the fluid handling structure relative to the substrate.
26. The method of clause 24 or 25, wherein the determining of the parameter comprises identifying a fluid loss pattern from the identified signs of fluid on the surface of the substrate.
27. The method of clause 26, wherein the method further comprises determining an angle at a vertex of the fluid loss pattern.
28. The method of clause 27, wherein the fluid handling structure crosses the fluid-pinning feature in a crossing direction, and wherein the vertex of the fluid loss pattern for which the angle is determined is a vertex which is separated from the fluid-pinning feature in the crossing direction.
29. The method of clause 27, wherein the identifying of the fluid loss pattern comprises fitting a triangle to the signs of fluid on the surface of the substrate, the triangle comprising first and second vertices at or near the fluid-pinning feature, and the method further comprises determining an angle at a third vertex of the triangle.
30. The method of clause 28 or 29, further comprising determining a de-wetting velocity of the substrate based on the determined angle.
31. The method of clause 30, further comprising determining a critical scanning speed based on the de-wetting velocity, wherein the critical scanning speed is a speed of the fluid handling structure relative to the substrate above which fluid is lost from the fluid handling structure.
32. The method of any of the preceding clauses, wherein the fluid handling structure passes over the fluid-pinning feature twice or more during the movement of the fluid handling structure relative to the substrate, optionally wherein fluid handling structure passes over the fluid-pinning feature three times or more during the movement of the fluid handling structure relative to the substrate, optionally wherein fluid handling structure passes over the fluid-pinning feature four times or more during the movement of the fluid handling structure relative to the substrate.
33. The method of clause 32, wherein the substrate comprises four quadrants, and the handling structure passes over the fluid-pinning feature in each of the four quadrants.
34. The method of clause 32 or 33, wherein the parameter is determined each time the fluid handling structure passes over the fluid-pinning feature.
35. The method of any of the preceding clauses, wherein the inspecting of the surface of the substrate comprises imaging the surface of the substrate.
36. The method of clause 35, wherein the imaging the surface of the substrate comprises imaging the surface of the substrate with an optical camera and/or an optical microscope, and/or wherein the imaging the surface of the substrate comprises bright-field microscopy.
37. The method of clause 36, wherein the inspecting of the surface of the substrate comprises imaging the surface of the substrate using a scanning electron microscope.
38. The method of any of the preceding clauses, wherein the inspecting of the surface of the substrate comprises obtaining a height map of the surface of the substrate, optionally wherein the obtaining of the height map of the surface of the substrate comprises obtaining the height map of the surface of the substrate using a level sensor, further optionally wherein the level sensor is an ultra-violet level sensor.
39. The method of any of the preceding clauses, wherein the inspecting of the surface of the substrate comprises use of scatterometry.
40. The method of any of the preceding clauses, wherein the inspecting of the surface of the substrate is performed by an inspection device within the lithographic apparatus.
41. The method of any of the preceding clauses, further comprising determining the presence of a fault or anomaly in the fluid handling structure based on the determined parameter.
42. The method of any of the preceding clauses, further comprising:
   determining to send a notification that maintenance is required or sending a notification that maintenance will be required in a specified time period, wherein the determination to send the notification is based on the determined parameter; and
   sending the notification.
43. A method for a lithographic apparatus comprising a fluid handling structure, wherein the fluid handling structure is configured to confine a fluid to a region of a surface of a substrate, and the method comprises:
   causing a movement of the fluid handling structure relative to the substrate;
   determining a thermal load on the substrate; and
   determining a parameter associated with the fluid handling structure and/or the wettability of the substrate based on the thermal load on the substrate.
44. The method of clause 43, further comprising determining an evaporation load on the substrate, wherein the evaporation load is a thermal load arising due to the evaporation of fluid from the surface of the substrate.
45. The method of clause 44 or 45, wherein the substrate is supported on a substrate support, and the determining of the thermal load on the substrate comprises determining the thermal load on the substrate support.
46. The method of clause 45, wherein the determining of the thermal load on the substrate support comprises measuring a temperature of a conditioning fluid in a conditioning system of the substrate support.
47. The method of clause 45, wherein the determining of the thermal load on the substrate support comprises measuring a temperature of the substrate support using one or more temperature sensors in or on the substrate support.
48. The method of clause 45, wherein the substrate support comprises one or more heating elements, the one or more heating elements each comprising an integrated temperature sensor, and the determining of the thermal load on the substrate support comprises measuring a temperature of the substrate support using the integrated temperature sensor(s).
49. The method of any of clauses 45 to 48, wherein the method comprises:
   causing a plurality of movements of the fluid handling structure relative to the substrate, each movement being at different relative speeds;
   determining a thermal load on the substrate for each of the plurality of movements;
   determining the parameter for each of the plurality of thermal loads.
50. The method of any of clauses 45 to 49, wherein the parameter is a critical scanning speed, wherein the critical scanning speed is a speed of the fluid handling structure relative to the substrate above which fluid is lost from the fluid handling structure.
51. The method of any of the preceding clauses, wherein the causing of the movement of the fluid handling structure relative to the substrate comprises moving the substrate, optionally wherein the causing of the movement of the fluid handling structure relative to the substrate comprises moving the substrate while the fluid handling structure remains stationary.
52. The method of clause 51, wherein the substrate is supported by a substrate support, and moving the substrate comprises moving the substrate support.
53. The method of any of the preceding clauses, further comprising varying one or more operating conditions of the fluid handling structure, optionally wherein the one or more operating conditions comprise one or more of:
   a distance between the fluid handling structure and the surface of the substrate;
   a flow-rate through a fluid extraction system; and
   a flow-rate through a gas knife system.
54. A method of manufacturing a device in a lithographic apparatus, the method comprising:
   projecting a beam of radiation onto a substrate via a layer of fluid, wherein the fluid is confined to a region of a surface of a substrate by a fluid handling structure; and
   causing a movement of the fluid handling structure relative to the substrate, wherein a speed of the fluid handling structure relative to the substrate is determined based on the determined parameter.
55. A lithographic apparatus configured to perform the method of any of clauses 1 to 54.
56. A computer program for a lithographic apparatus, the computer program comprising instructions which, when executed by a processor, cause the lithographic apparatus to perform the method of any of clauses 1 to 54.

The descriptions above are intended to be illustrative, not limiting. Thus, it will be apparent to one skilled in the art that modifications may be made to the invention as described without departing from the scope of the claims set out below.

## Claims

1. A method for a lithographic apparatus comprising a fluid handling structure, wherein the fluid handling structure is configured to confine a fluid to a region of a surface of a substrate, and the method comprises:
causing a movement of the fluid handling structure relative to the substrate, wherein a speed of the fluid handling structure relative to the substrate during the movement varies as a function of the position of the fluid handling structure relative to the substrate;
inspecting the surface of the substrate; and
determining a parameter associated with the fluid handling structure and/or the wettability of the substrate based on the inspecting of the surface of the substrate.

2. The method of claim 1, wherein the inspecting of the surface of the substrate comprises identifying signs of fluid on the surface of the substrate, desirably wherein the inspecting of the surface of the substrate comprises identifying signs of fluid remaining on the surface of the substrate after the movement of the fluid handling structure relative to the substrate.

3. The method of claim 1 or 2, wherein the signs of fluid on the substrate comprise one or more of:
fluid droplets on the surface of the substrate;
bubbles on the surface of the substrate;
marks or stains on the surface of the substrate by a fluid droplet or bubble; and
defects in a pattern imparted to the surface of the substrate, and/or
wherein the substrate comprises a layer of photoresist, and the surface of the substrate is a surface of the layer of photoresist, and/or
wherein the parameter is a critical scanning speed, and the critical scanning speed is a speed of the fluid handling structure relative to the substrate above which fluid is lost from the fluid handling structure, and/or
wherein the causing the movement of the fluid handling structure relative to the substrate is such that the fluid handling structure moves across the surface of the substrate along a path.

4. The method of claim 3, further comprising identifying a critical point on the path, wherein the critical point is a point at which the incidence of signs of fluid on the surface of the substrate exceeds a threshold, desirably wherein the critical scanning speed is determined based on the identified critical point, an/or wherein the path is linear, and/or wherein the path comprises one or more corners, optionally wherein the path is a meandering path.

5. The method of any of the preceding claims, wherein, during the movement of the fluid handling structure relative to the substrate, the speed of the fluid handling structure relative to the substrate increases from a first speed to a second speed and/or decreases from a second speed to a first speed, desirably wherein the second speed is a maximum speed of the fluid handling structure relative to the substrate, and/or
wherein the method comprises:
causing a first movement of the fluid handling structure relative to the substrate in a first direction, wherein a speed of the fluid handling structure relative to the substrate varies as a function of the position of the fluid handling structure relative to the substrate;
performing a first inspection of the surface of the substrate;
determining a first parameter associated with the fluid handling structure and/or the wettability of the substrate based on the first inspection of the surface of the substrate;
causing a second movement of the fluid handling structure relative to the substrate in a second direction, wherein a speed of the fluid handling structure relative to the substrate varies as a function of the position of the fluid handling structure relative to the substrate, and wherein the second direction is different to the first direction;
performing a second inspection of the surface of the substrate;
determining a second parameter associated with the fluid handling structure and/or the wettability of the substrate based on the second inspection of the surface of the substrate.

6. A method for a lithographic apparatus comprising a fluid handling structure, wherein the fluid handling structure is configured to confine a fluid to a region of a surface of a substrate, and the method comprises:
causing a movement of the fluid handling structure relative to the substrate, wherein the fluid handling structure passes over a fluid-pinning feature during the movement of the fluid handling structure relative to the substrate;
inspecting the surface of the substrate; and
determining a parameter associated with the fluid handling structure and/or the wettability of the substrate based on the inspecting of the surface of the substrate.

7. The method of claim 6, wherein the fluid-pinning feature comprises a change in a wettability of a surface and/or a topological feature on the surface of the substrate, and/or wherein the fluid-pinning feature is an edge of the substrate, and/or wherein the fluid-pinning feature is a boundary between an edge of the substrate and a cover ring, wherein the cover ring is disposed radially outward of the substrate.

8. The method of claim 6 or 7, wherein the fluid-pinning feature is a boundary between a first portion of the surface of the substrate and a second portion of the surface of the substrate, wherein the first portion of the surface of the substrate has a different wettability to the second portion of the surface of the substrate, desirably wherein the substrate comprises a layer of photoresist, and the second portion of the surface of the substrate is formed by the layer of photoresist, desirably wherein the substrate comprises a main body and a layer of photoresist, wherein the first portion of the surface of the substrate is formed by the main body, optionally wherein the first portion of the surface if formed by removing photoresist from the main body, desirably wherein the first portion of the substrate is formed by a coating on the main body, wherein the coating is different to the photoresist, optionally wherein the coating comprises hexamethyldisilazane, desirably wherein the second portion of the substrate is a circular portion in a radial centre of the substrate, and the first portion is an annular portion radially outward of the first portion.

9. The method of any of claims 6-8, wherein the inspecting of the surface of the substrate comprises identifying signs of fluid on the surface of the substrate, and/or wherein the inspecting of the surface of the substrate comprises identifying signs of fluid remaining on the surface of the substrate after the movement of the fluid handling structure relative to the substrate, desirably wherein the determining of the parameter comprises identifying a fluid loss pattern from the identified signs of fluid on the surface of the substrate, desirably wherein the determining of the parameter comprises identifying a fluid loss pattern from the identified signs of fluid on the surface of the substrate, desirably wherein the method further comprises determining an angle at a vertex of the fluid loss pattern, desirably wherein the fluid handling structure crosses the fluid-pinning feature in a crossing direction, and wherein the vertex of the fluid loss pattern for which the angle is determined is a vertex which is separated from the fluid-pinning feature in the crossing direction, desirably wherein the identifying of the fluid loss pattern comprises fitting a triangle to the signs of fluid on the surface of the substrate, the triangle comprising first and second vertices at or near the fluid-pinning feature, and the method further comprises determining an angle at a third vertex of the triangle, desirably further comprising determining a de-wetting velocity of the substrate based on the determined angle, desirably further comprising determining a critical scanning speed based on the de-wetting velocity, wherein the critical scanning speed is a speed of the fluid handling structure relative to the substrate above which fluid is lost from the fluid handling structure.

10. The method of any of the preceding claims, wherein the fluid handling structure passes over the fluid-pinning feature twice or more during the movement of the fluid handling structure relative to the substrate, optionally wherein fluid handling structure passes over the fluid-pinning feature three times or more during the movement of the fluid handling structure relative to the substrate, optionally wherein fluid handling structure passes over the fluid-pinning feature four times or more during the movement of the fluid handling structure relative to the substrate, desirably wherein the substrate comprises four quadrants, and the handling structure passes over the fluid-pinning feature in each of the four quadrants, desirably wherein the parameter is determined each time the fluid handling structure passes over the fluid-pinning feature.

11. The method of any of the preceding claims, wherein the inspecting of the surface of the substrate comprises imaging the surface of the substrate, desirably wherein the imaging the surface of the substrate comprises imaging the surface of the substrate with an optical camera and/or an optical microscope, and/or wherein the imaging the surface of the substrate comprises bright-field microscopy, desirably wherein the inspecting of the surface of the substrate comprises imaging the surface of the substrate using a scanning electron microscope.

12. The method of any of the preceding claims, wherein the inspecting of the surface of the substrate comprises obtaining a height map of the surface of the substrate, optionally wherein the obtaining of the height map of the surface of the substrate comprises obtaining the height map of the surface of the substrate using a level sensor, further optionally wherein the level sensor is an ultra-violet level sensor, and/or wherein the inspecting of the surface of the substrate comprises use of scatterometry, and/or wherein the inspecting of the surface of the substrate is performed by an inspection device within the lithographic apparatus, and/or further comprising determining the presence of a fault or anomaly in the fluid handling structure based on the determined parameter, and/or
further comprising:
determining to send a notification that maintenance is required or sending a notification that maintenance will be required in a specified time period, wherein the determination to send the notification is based on the determined parameter; and
sending the notification, and/or
further comprising determining a thermal load on the substrate.

13. The method of any of the preceding claims, wherein the causing of the movement of the fluid handling structure relative to the substrate comprises moving the substrate, optionally wherein the causing of the movement of the fluid handling structure relative to the substrate comprises moving the substrate while the fluid handling structure remains stationary, desirably wherein the substrate is supported by a substrate support, and moving the substrate comprises moving the substrate support, and/or
further comprising varying one or more operating conditions of the fluid handling structure, optionally wherein the one or more operating conditions comprise one or more of:
a distance between the fluid handling structure and the surface of the substrate;
a flow-rate through a fluid extraction system; and
a flow-rate through a gas knife system.

14. A method of manufacturing a device in a lithographic apparatus, the method comprising:
projecting a beam of radiation onto a substrate via a layer of fluid, wherein the fluid is confined to a region of a surface of a substrate by a fluid handling structure; and
causing a movement of the fluid handling structure relative to the substrate, wherein a speed of the fluid handling structure relative to the substrate is determined based on the determined parameter.

15. A lithographic apparatus configured to perform the method of any of the preceding claims.
